# EUROPÄISCHE PATENTSCHRIFT

(11) **EP 0 263 391 B1**
(45) Veröffentlichungstag und Bekanntmachung des Hinweises auf die Patenterteilung: **05.05.1993**
(21) Anmeldenummer: 87114134.7
(22) Anmeldetag: 28.09.1987
(51) Int. Cl.: H05K 5/00, H05K 7/14

(54) **Vorrichtung zum Empfangen, Aufbereiten, Verwerten und Weiterleiten elektrischer Signale**
Device for receiving, preparing, exploiting and transmitting electrical signals
Dispositif pour recevoir, préparer, exploiter et transmettre des signaux électriques

(30) Priorität: 04.10.1986 DE 3633800
(43) Veröffentlichungstag der Anmeldung: 13.04.1988
(73) Patentinhaber: Endress u. Hauser GmbH u. Co., D-79689 Maulburg (DE)
(72) Erfinder: Hintner, Gottfried, D-7860 Schopfheim (DE); Franz, Hans-Juergen, D-7853 Steinen (DE); Grab, Manfred, D 7864 Maulburg (DE)
(74) Vertreter: Leiser, Gottfried, Dipl.-Ing.

(56) Entgegenhaltungen:
- WO-A-80/00381
- DE-A- 3 413 533

## Beschreibung

Die Erfindung betrifft eine Vorrichtung zum Empfangen, Aufbereiten, Verwerten und Weiterleiten elektrischer Signale mit einem an einer Wandleiste lösbar angebrachten Grundsockel zum Anschluß der Verbindungsleitungen für die Übertragung der Meßsignale und der zur Funktion der Vorrichtung benötigten elektrischen Energie, einer Auswertevorrichtung zum Aufbereiten und Verwerten der empfangenen Meßsignale, einem Transformator zur Umwandlung der Versorgungsspannung in die Betriebsspannung und mit einem den Grundsockel, die Auswertevorrichtung und den Transformator umschließenden Gehäuse.

Für die Überwachung von Betriebsvorgängen, z.B. während eines Misch- oder Fertigungsprozesses, oder die Überwachung des Befüllungszustandes von Behältern befindet sich im allgemeinen nur der das physikalische Meßsignal erzeugende Meßwertaufnehmer direkt an der Meßstelle. Die meisten Meßwertaufnehmer verfügen dann über eine elektrische Schaltung, die die physikalische Größe in ein elektrisches Meßsignal umwandelt. Die eigentliche Auswertung und Anzeige des Meßsignals übernimmt eine Auswertevorrichtung, die entfernt von der Meßstelle (z.B. in einer Schaltwarte) untergebracht ist. Meßwertaufnehmer und Auswertevorrichtung sind dabei über eine Verbindungsleitung miteinander verbunden, über die außer dem Meßsignal auch die für die Funktion des Meßwertaufnehmers notwendige elektrische Energie von der Auswertevorrichtung zum Meßwertaufnehmer übertragen wird.

Zur Überwachung von Betriebsvorgängen sind in der Regel mehrere Meßaufnehmer notwendig, deren elektrische Signale zur Schaltwarte übertragen werden, in der die Auswertevorrichtungen installiert sind. Dort sind die Auswertevorrichtungen innerhalb eines Schaltschrankes oder in einem Baugruppenträger untergebracht. Dabei sind die Auswertevorrichtungen nicht von einem Gehäuse umschlossen, sondern im Schaltschrank oder Baugruppenträger aneinandergereiht.

Zur Überwachung von Betriebsvorgängen ist es jedoch auch notwendig, entweder parallel zur Auswertevorrichtung in der Schaltwarte oder unabhängig davon Meßwerte an einem anderen Ort innerhalb des Betriebsablaufes zu überwachen. Dabei handelt es sich in der Regel nicht um die Überwachung des komplexen Betriebsablaufes, sondern nur wenige gezielte Meßwerte müssen hier, z.B. in der Nähe des Meßwertaufnehmers, angezeigt werden. Dementsprechend sind an solchen separaten Überwachungsplätzen nur wenige Auswertevorrichtungen installiert. Der Einbau eines Schaltschrankes oder eines Baugruppenträgers lohnt sich für diese wenigen Auswertevorrichtungen nicht, so daß diese mittels einer Wandleiste lösbar am Überwachungsort montiert werden. Dazu muß aber jede Auswertevorrichtung von einem schützenden Gehäuse umschlossen sein.

Diese beiden unterschiedlichen Einbauarten von Vorrichtungen dieser Art entweder in einem Baugruppenträger oder in einem eigenen Gehäuse sind beispielsweise aus dem Prospekt "Füllstandmessung mit Impuls-Echo-Geräten" der Firma VEGA Grieshaber GmbH & Co., 7622 Schiltach, bekannt. Dabei sind alle Bestandteile der Vorrichtung zu einer einzigen, für sich abgeschlossenen Einheit zusammengebaut und verdrahtet, die dann als Ganzes entweder in den Baugruppenträger oder in das Gehäuse eingesetzt wird. Nach dem bisherigen Stand der Technik sind auch Auswertevorrichtungen bekannt, die einen von dem Gehäuse lösbaren Sockelteil aufweisen, der an einer Wandleiste befestigt werden kann und elektrische Mittel zum Anschluß der Verbindungsleitungen umschließt. Auch in diesem Fall sind die im Gehäuse enthaltenen Bestandteile der Vorrichtung zu einer einzigen, für sich abgeschlossenen Einheit zusammengebaut.

Bei der Überwachung von Betriebsvorgängen kann es vorkommen, daß bei Änderung des Betriebsablaufs an einer externen Überwachungsstelle anstelle der bisherigen andere physikalische Meßwerte überwacht werden sollen. Dies bedeutet, daß die elektrischen Signale anderer Meßwertaufnehmer zur Überwachungsstelle übertragen werden. Die Aufbereitung und Verwertung der neu übertragenen Signale mit der bisherigen Auswertevorrichtung ist nicht möglich, so daß auch dieses entsprechend dem jetzt zu überwachenden Meßwert geändert werden muß. Bei den bisher bekannten Vorrichtungen, bei denen das Gehäuse alle für die Funktion der Auswertevorrichtung benötigten Baugruppen umschließt, mußte bei Änderung der Meßwerte die komplette Auswertevorrichtung ausgetauscht werden.

Aufgabe der Erfindung ist es, eine Vorrichtung zum Empfangen, Aufbereiten, Verwerten und Weiterleiten elektrischer Signale zu schaffen, die mit wenigen Handgriffen bei Bedarf in einzelne, für sich abgeschlossene Funktionselemente zerlegt und mit der neuen Funktion entsprechenden anderen gleichförmigen Funktionselementen zusammengefügt werden kann.

Zur Lösung dieser Aufgabe weist die Vorrichtung nach der Erfindung die folgenden Merkmale auf:
a) die Auswertevorrichtung, der Transformator und der Grundsockel sind jeweils für sich abgeschlossene Funktionselemente;
b) das Gehäuse weist durch elektrisch isolierende Trennwände gebildete Bereiche auf, in die jeweils eines der von der Auswertevorrichtung, dem Transformator bzw. dem Grundsockel gebildeten Funktionselemente einschiebbar ist;
c) der Grundsockel weist in seinem Inneren Abschlußklemmen für den Anschluß der die Meßsignale und die Versorgungsspannungen übertragenden Verbindungsleitungen sowie Steckverbindungsteile auf;
d) die Auswertevorrichtung und der Transformator weisen Steckverbindungsteile auf, die in die Steckverbindungsteile des Grundsockels eingreifen, wenn die Funktionselemente in die zugeordneten Bereiche des Gehäuses eingeschoben sind;
e) der Grundsockel weist eine Leiterplatte auf, deren Leiterbahnen mit den Anschlußklemmen und mit den Steckverbindungsteilen in elektrischem Kontakt stehen und ausschließlich die elektrischen Verbindungen der Funktionselemente miteinander sowie mit den Verbindungsleitungen herstellen.

Vorteilhafte Ausgestaltungen der Erfindung sind in den Unteransprüchen gekennzeichnet.

Ein Ausführungsbeispiel der Erfindung ist in den Zeichnungen dargestellt.

Es zeigen:
- Fig. 1: eine Übersichtszeichnung mit den einzelnen Funktionselementen des Erfindungsgegenstandes.
- Fig. 2: einen Schnitt durch das Funktionselement Gehäuse.
- Fig. 3: einen Schnitt durch das Funktionselement Grundsockel.

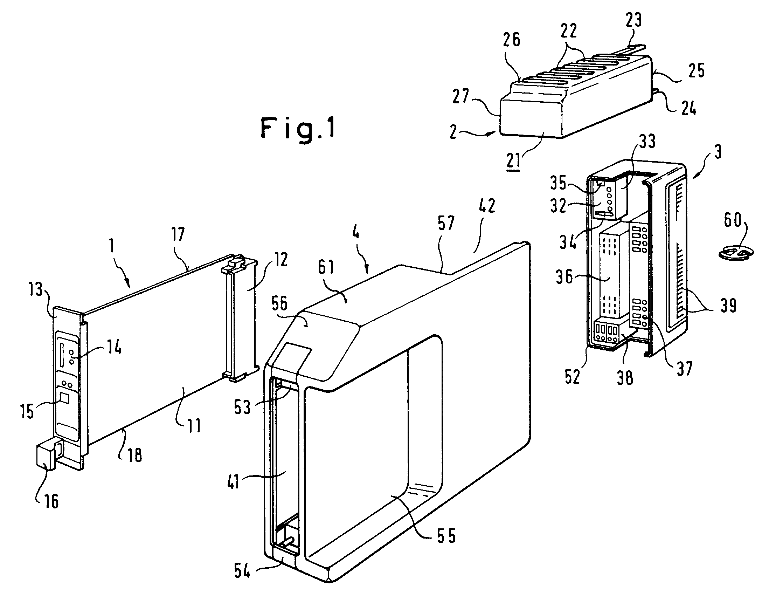

In Fig. 1 sind die einzelnen den Erfindungsgegenstand umfassenden Funktionselemente dargestellt, wobei jedes für sich eine räumliche und/oder elektrisch abgeschlossene Einheit bildet. Unter Pos. 1 ist die Auswertevorrichtung dargestellt, sie besteht aus dem Schaltungsträger 11, der mit nicht dargestellten elektronischen Bauelementen zur Aufbereitung und Verwertung der Meßsignale bestückt ist. Dazu besitzt die Auswertevorrichtung 1 die Federleiste 12 einer Steckverbindung, über die die Auswertevorrichtung 1 die Meßsignale und die für die Funktion notwendige elektrische Energie empfängt.

Am anderen Ende des Schaltungsträgers 11 ist an der Auswertevorrichtung 1 rechtwinklig zum Schaltungsträger 11 eine Frontplatte 13 angeordnet. Zur Darstellung des Meßwertes dienen den Signalwert darstellende Leuchtdioden 14 und ein Anzeigeinstrument 15, die in der Frontplatte 13 installiert sind. Weiter ist die Auswertevorrichtung 1 mit dem mit der Frontplatte 13 verbundenen Handgriff 16 ausgestattet. Der Handgriff 16 dient dazu, die Auswertevorrichtung 1 in die für ihre Aufnahme bestimmte Öffnung 41 des Gehäuses 4 einzuschieben. Die sich in Längsrichtung erstreckende obere und untere Kante 17, 18 des Schaltungsträgers 11 bildet dabei die Führung der Auswertevorrichtung 1 in der Öffnung 41 des Gehäuses 4.

Der Transformator 2 ist in die Öffnung 42 des Gehäuses 4 einschiebbar. Seine Aufgabe ist, die empfangene Spannung, die der besseren Erklärung wegen beispielhaft die Netzspannung sein soll, in die Betriebsspannung umzuwandeln.

Dabei umfaßt der Transformator 2 auch elektrische Mittel zur Umwandlung der empfangenen Wechselspannung in eine Gleichspannung.

Der Transformator 2 ist von einem die elektrischen Bauteile einschließenden Gehäuse 21 umgeben. Dies ist vorteilhaft aus einem geeigneten Kunststoff als Spritzteil hergestellt. Zur Ableitung der Betriebswärme dienen die auf der Ober- und auf der dem Betrachter abgewandten Seite quer zu seiner Längsrichtung angeordneten Kühlrippen 22. Weiter besitzt der Transformator 2 ein Federelement 23, das an das Gehäuse 21 angespritzt sein kann. Ein elektrischer Kontakt 24 besteht aus mehreren auf der Rückseite 25 des Transformators 2 angeordneten Kontaktfahnen, wovon nur eine sichtbar ist. Über diese Kontaktfahnen 24 ist der Transformator 2 zum Empfang der Netzspannung und der Abgabe der Betriebsspannung elektrisch mit dem Grundsockel 3 verbunden; das Federelement 23 dient zur Sicherung des Transformators 2 gegen ein unbeabsichtigtes Lösen.

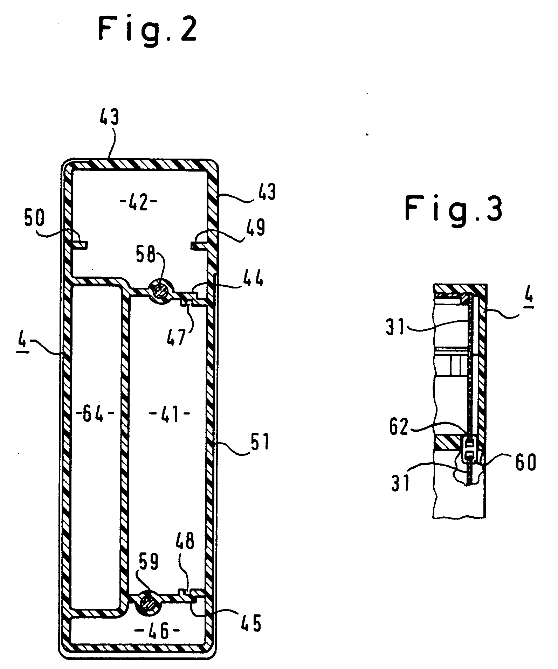

Der Grundsockel 3 besitzt auf seiner Rückseite nicht dargestellte Verbindungselemente, wodurch der Grundsockel 3 an einer Wandleiste befestigt wird. Weiter umschließt der Grundsockel 3 eine Leiterplatte 31 (Fig. 3). Die auf ihr geführten Leiterbahnen bilden die einzige elektrische Verbindung zwischen den Funktionselementen 1, 2, 3 des Erfindungsgegenstandes. Der Grundsockel 3 umschließt die Anschlußelemente 32, 36, 37, 38, die angespritzt mit dem Grundsockel 3 eine Einheit bilden. Die kombinierte Klemmen-Federleiste 32 ist mit Schraubklemmen 33 versehen, die zum Anlegen der Netzspannung dienen. Weiter gehören zu der Klemmen-Federleiste 32 die Kontaktfedern 34. Die Kontaktfedern 34 dienen zur Aufnahme der Steckfahnen 24 und bilden eine elektrische Verbindung für die Netzspannung und für die Betriebsspannung. Sind die Steckfahnen 24 des Transformators 2 in die Kontaktfedern 34 eingeführt, rastet das Federelement 23 in der Öffnung 35 ein.

Der Grundsockel 3 umschließt außerdem die Federleiste 36, sie ist die elektrische Verbindung zur Messerleiste 12 der Auswertevorrichtung 1. Im zusammengeführten, d.h. geschlossenen Zustand werden über die Steckverbindung 12, 36 die für die Funktion der Auswertevorrichtung 1 notwendige Betriebsspannung vom Federkontakt 34 über die nicht dargestellten Leiterbahnen der Leiterplatte 31 zur Federleiste 36 und über die Messerleiste 12 an die Auswertevorrichtung 1 übertragen. Auch die Verbindung für die Meßwertsignale, die vom Meßwertaufnehmer über die Verbindungsleitung übertragen werden, wird über die Anschlußklemme 38, die Leiterplatte 31 und die Steckverbindungen 12, 36 zur Auswertevorrichtung 1 geführt. Dazu ist die nicht dargestellte Verbindungsleitung mit der Anschlußklemme 38 verbunden.

Die Auswertevorrichtung 1 stellt aber auch weitere elektrische Signale bereit, die der Steuerung von Betriebseinrichtungen, wie z.B. dem Öffnen und Schließen von Ventilen, dem Ein- und Ausschalten von Motoren o.ä. Vorgängen dienen. Die Übertragung dieser Signale läuft über eine elektrische Verbindung, die durch die Messerleiste 12, die Federleiste 36, die Leiterbahnen der Leiterplatte 31 und die Klemmenleiste 37 gebildet wird.

Die Anschlußklemme 38, mit dem nicht dargestellten Verbindungskabel verbunden, stellt auch die elektrische Verbindung für die Stromversorgung des Meßwertaufnehmers her, wobei die Anschlußklemme 38 wiederum über die Leiterbahnen 31, die Steckverbindung 12, 36 mit der Auswertevorrichtung 1 in elektrischem Kontakt steht.

Zur Überwachung der Meßwerte an einer beschriebenen separaten Überwachungsstelle ist es unter Umständen nötig, von einer Vorrichtung empfangene Meßwertsignale an eine zweite benachbart montierte Vorrichtung weiterzugeben und dort zur Anzeige der Meßwertsignale oder zum Ansteuern von Betriebselementen anzuschließen.

In weiterer vorteilhafter Ausgestaltung der Erfindung hat der Grundsockel 3 schlitzförmige Öffnungen 39, die sich ein Stück in Längsrichtung des Gehäuses 4 erstrecken. Diese schlitzförmigen Öffnungen 39 sind auch auf der in Fig. 1 nicht einsehbaren Längsseite des Grundsockels 3 angeordnet. Zur elektrischen Verbindung der Auswertevorrichtung 1 mit der Auswertevorrichtung einer direkt benachbart angeordneten zweiten Vorrichtung nach der Erfindung kann ein Federelement 60 in die schlitzartigen Öffnungen 39 des Grundsockels 3 eingeführt werden. Wie in Fig. 3 dargestellt, bildet das Federelement 60 dann eine elektrische Verbindung mit dafür bestimmten Leiterbahnen der Leiterplatte 31. Dazu sind an der Randzone der Leiterplatte 31 in an sich bekannter Weise Kontaktflächen 62 angeordnet, die von zwei Schenkeln des Federelementes 60 umschlossen werden. Diese Kontaktflächen 62 sind auf beiden Randflächen der sich in Längsrichtung erstreckenden Kanten der Leiterplatte 31 ausgebildet. So können die Meßwertsignale der Auswertevorrichtung 1 an eine benachbart angeordnete zweite oder weitere Auswertevorrichtung weitergeleitet werden, unabhängig davon, ob diese rechts oder links vom beschriebenen Erfindungsgegenstand montiert ist.

Die Verbindung kann auch über dafür vorgesehene Leiterbahnen der Leiterplatte 31 für die Übertragung der Betriebsspannung verwendet werden, so daß benachbart installierte Auswertevorrichtungen von einer einzigen Netzzuführung mit der benötigten elektrischen Energie versorgt werden können. Dazu ist die Leiterplatte 31 wiederum mit Kontaktflächen 62 versehen, die mit den Federelementen 60 in elektrischem Kontakt sind, wobei die Federelemente 60 ebenfalls durch die Längsschlitze 39 geführt werden.

In Fig. 1 ist das Gehäuse 4 in perspektivischer Ansicht und in Fig. 2 der besseren Erklärung wegen im Schnitt dargestellt.

Das Gehäuse 4 ist aus einem Kunststoff, vorteilhaft aus Acrylnitril-Butadien-Styrol-Copolymerisat hergestellt. Die die elektrischen Funktionselemente 1, 2, 3 des Erfindungs gegenstandes umschließende Außenwand ist in Fig. 2 mit 43 markiert. Wie aus Fig. 2 weiter ersichtlich, bilden die Trennwände 44, 45 im Gehäuse 4 einzelne Hohlräume 41, 42, 46, die zur Aufnahme der elektrischen Funktionselemente dienen. So ist die Auswertevorrichtung 1 im Hohlraum 41, der Netztransformator 2 im Hohlraum 42 und der Grundsockel 3 im Hohlraum 46 plaziert, der sich in Fig. 2 von der Zeichenebene hin zum Betrachter erstreckt und die Hohlräume 41, 42 einschließt.

Zur Führung und Haltung der Auswertevorrichtung 1 sind an die Zwischenwände 44, 45 Nuten 47, 48 angeformt. Sie dienen der Aufnahme der sich in Längsrichtung erstreckenden oberen und unteren Kante 17, 18 des Schaltungsträgers 11 und bilden somit eine Führung für die Auswertevorrichtung 1 im Hohlraum 41. Die Stege 49, 50 im Hohlraum 42 dienen der gleichen Aufgabe für den Transformator 2.

Das Gehäuse 4 ist mit einem teilweise umlaufenden, mit einer Führungskante 51 versehenen Randbereich ausgestattet, der sich in Längsrichtung des Gehäuses 4 in Richtung des Grundsockels 3 erstreckt. Und am Grundsockel 3 ist eine dem Randbereich 51 gegenüberliegende Fase 52 angeformt. Für die Verbindung des Gehäuses 4 mit dem Grundsockel 3 ist der Randbereich 51 und die Fase 52 so gestaltet, daß die Fase 52 in den Randbereich 51 einrastet und eine staubdichte Verbindung bildet.

Zur besseren Ein- und Ausführung der Auswertevorrichtung 1 in das Gehäuse 4 sind an dem Gehäuse 4 zwei Klappen 53, 54 angeordnet, die durch nicht sichtbare Scharniere so im Gehäuse 4 gehalten werden, daß sie vor dem Herausziehen der Auswertevorrichtung 1 aus dem Gehäuse 4 aufgeklappt und nach Einführung einer anderen Auswertevorrichtung wieder zugeklappt werden können, wodurch mit dem Aufklappen die mit dem Hohlraum 41 in Verbindung stehende Öffnung vergrößert wird.

In das Gehäuse 4 ist eine Ausnehmung 55 angeformt, die sich auf der der Öffnung 41 zugewandten Seite in einem Teilbereich quer zur Gehäuselängsachse erstreckt. Diese Ausnehmung 55 bildet eine Grifffläche zur Erleichterung des Abziehens des Gehäuses 4 von dem Grundsockel 3. Der nicht von der Ausnehmung 55 durchdrungene, dem Grundsockel 3 zugewandte Bereich des Gehäuses 4 bildet einen Hohlraum 64, der zur Aufnahme der Anschlußdrähte der Verbindungsleitungen dient.

In einer weiteren vorteilhaften Ausgestaltung des Gehäuses 4 erstreckt sich die Oberseite 61 in dem der Frontplatte 13 zugewandten Bereich 56 platzsparend in einem Winkel von ca. 30° zur Gehäuseoberseite 61. Weiter hat die Gehäuseoberseite 61 eine Aussparung 57, die den Hohlraum 42 in einem Bereich, der sich von dem dem Grundsockel 3 zugewandten Ende entlang der Längsachse des Gehäuses 4 erstreckt und in einem Winkel von 90°, Teilbereiche der Oberseite 61 sowie der von dem Betrachter abgewandten Seitenfläche des Gehäuses 4 umfaßt. Die Aussparung dient dem Zweck, die mit Kühlrippen versehene Oberfläche des Transformators 2 so mit der Umwelt in direkten Kontakt zu bringen, daß die bei der Transformation entstehende Wärme über die Kühlrippen abgeleitet wird. Der Transformator 2 ist dabei so im Hohlraum 42 gehalten, daß die sich zwischen den Kühlrippen 22 befindliche Oberfläche 26, 27 des Transformators 2 mit der Oberfläche des Gehäuses 4 eine durchgehende ebene Fläche bildet, aus der die Kühlrippen 22 hervorstehen.

An der Rückseite 25 des Transformators 2 ist ein für den Betrachter nicht sichtbarer Randbereich ausgebildet, der die Fortsetzung des Randbereiches 51 des Gehäuses 4 bildet. Somit ist gewährleistet, daß bei Zusammenfügen der Teile 2, 3, 4 die zwischen dem Randbereich 51 und der Fase 52 gebildete staubdichte Verbindung auch die Aussparung 57 einschließt.

Als einzige Schraubverbindung hat der Erfindungsgegenstand zwei das Gehäuse 4 durchdringende Schraubenbolzen 58, 59, durch die die Vorrichtung zum Empfangen, Aufbereiten, Verwerten und Weiterleiten elektrischer Signale nach dem Zusammenfügen gegen ein unbeabsichtigtes Lösen gesichert wird.

Es ist nun leicht ersichtlich, wie mit dem Erfindungsgegenstand durch Abziehen der einzelnen, in einer geschlossenen räumlichen und/oder elektrischen Einheit vorliegenden Funktionselemente und dem Wiederzusammenfügen nach Austausch derselben mit wenigen Handgriffeneine für einen anderen Meßwert bestimmte Überwachungsvorrichtung aufgebaut werden kann.

## Patentansprüche

1. Vorrichtung zum Empfangen, Aufbereiten, Verwerten und Weiterleiten elektrischer Signale mit einem an einer Wandleiste lösbar angebrachten Grundsockel zum Anschluß der Verbindungsleitungen für die Übertragung der Meßsignale und der zur Funktion der Vorrichtung benötigten elektrischen Energie, einer Auswertevorrichtung zum Aufbereiten und Verwerten der empfangenen Meßsignale, einem Transformator zur Umwandlung der Versorgungsspannung in die Betriebsspannung und mit einem den Grundsockel, die Auswertevorrichtung und den Transformator umschließenden Gehäuse, gekennzeichnet durch die folgenden Merkmale:
a) die Auswertevorrichtung (1), der Transformator (2) und der Grundsockel (3) sind jeweils für sich abgeschlossene Funktionselemente;
b) das Gehäuse (4) weist durch elektrisch isolierende Trennwände (44, 45) gebildete Bereiche (41, 42, 46) auf, in die jeweils eines der von der Auswertevorrichtung (1), dem Transformator (2) bzw. dem Grundsockel (3) gebildeten Funktionselemente einschiebbar ist;
c) der Grundsockel (3) weist in seinem Inneren Anschlußklemmen (32, 37, 38) für den Anschluß der die Meßsignale und die Versorgungsspannungen übertragenden Verbindungsleitungen sowie Steckverbindungsteile (34, 36) auf;
d) die Auswertevorrichtung (1) und der Transformator (2) weisen Steckverbindungsteile (12, 24) auf, die in die Steckverbindungsteile (34, 36) des Grundsockels (3) eingreifen, wenn die Funktionselemente (1, 2, 3) in die zugeordneten Bereiche (41, 42, 46) des Gehäuses (4) eingeschoben sind;
e) der Grundsockel (3) weist eine Leiterplatte (31) auf, deren Leiterbahnen mit den Anschlußklemmen (32, 37, 38) und mit den Steckverbindungsteilen (34, 36) in elektrischem Kontakt stehen und ausschließlich die elektrischen Verbindungen der Funktionselemente (1, 2, 3) miteinander sowie mit den Verbindungsleitungen herstellen.

2. Vorrichtung nach Anspruch 1, dadurch gekennzeichnet, daß an den Funktionselementen (1, 2, 3) bzw. am Gehäuse (4) Führungs- und Befestigungsmittel (17, 18, 23, 35, 53, 54) vorgesehen sind, welche die Funktionselemente (1, 2, 3) in den zugeordneten Bereichen (41, 42, 43) des Gehäuses (4) führen und halten.

3. Vorrichtung nach Anspruch 1 oder 2, dadurch gekennzeichnet, daß die elektrischen Bauteile des Transformators (2) von einem elektrisch isolierenden Gehäuse (21) umschlossen sind.

4. Vorrichtung nach Anspruch 3, dadurch gekennzeichnet, daß am Gehäuse (21) des Transformators (2) federnde Mittel (23) vorgesehen sind, die in Öffnungen (35) des Grundsockels (3) eingreifen, wenn der Transformator (2) und der Grundsockel (3) in das Gehäuse (4) eingeführt sind.

5. Vorrichtung nach Anspruch 3 oder 4, dadurch gekennzeichnet, daß auf der Oberfläche von zwei in einem Winkel von 90° zueinander angeordneten, in der Längsrichtung verlaufenden Außenwänden (26, 27) des Gehäuses (21) des Transformators (2) in Querrichtung verlaufende Kühlrippen (22) angeordnet sind.

6. Vorrichtung nach Anspruch 5, dadurch gekennzeichnet, daß das Gehäuse (4) eine Aussparung (57) hat, in der der Transformator (2) so gehalten ist, daß die die Kühlrippen (26) aufweisenden Außenwände (26, 27) des Transformators (2) die flächenmäßige Fortsetzung des Gehäuses (4) bilden und die Kühlrippen (26) aus der Oberfläche des Gehäuses (4) hervorstehen.

7. Vorrichtung nach einem der Ansprüche 1 bis 6, dadurch gekennzeichnet, daß der Grundsockel (3) aus einem elektrisch isolierenden Material gebildet ist.

8. Vorrichtung nach Anspruch 7, dadurch gekennzeichnet, daß die Isolierteile der Anschlußklemmen (32, 37, 38) und der Steckverbindungsteile (34, 36) des Grundsockels einstückig mit dem Grundsockel (3) geformt sind.

9. Vorrichtung nach Anspruch 7 oder 8, dadurch gekennzeichnet, daß die Außenwand des Grundsockels (3) Öffnungen (39) aufweist, durch welche Federelemente (60) durchführbar sind, die mit Leiterbahnen der Leiterplatte (31) in elektrischen Kontakt zu bringen sind, um Verbindungen zwischen zwei nebeneinander angeordneten Vorrichtungen herzustellen.

10. Vorrichtung nach einem der vorhergehenden Ansprüche, dadurch gekennzeichnet, daß das Gehäuse (4) aus einem isolierenden Kunststoff hergestellt ist.

11. Vorrichtung nach Anspruch 10, dadurch gekennzeichnet, daß das Gehäuse aus einem Acrylnitril-Butadien-Styrol-Copolymerisat als Spritzteil hergestellt ist.

12. Vorrichtung nach einem der vorhergehenden Ansprüche, dadurch gekennzeichnet, daß am Gehäuse (4), am Transformator (2) und am Grundsockel (3) sich gegenüberliegende Teile (51, 52) angeformt sind, die den Transformator (2), den Grundsockel (3) und das Gehäuse (4) staubdicht miteinander verbinden.

13. Vorrichtung nach einem der vorhergehenden Ansprüche, dadurch gekennzeichnet, daß das Gehäuse (4) auf der dem Grundsockel (3) abgewandten Seite eine Öffnung (41) hat, in die die Auswertevorrichtung (1) einschiebbar ist.

14. Vorrichtung nach Anspruch 13, dadurch gekennzeichnet, daß am Gehäuse (4) ausklappbare Gehäuseteile (53, 54) vorhanden sind, durch welche die Öffnung (41) zur Ein- und Ausführung der Auswertevorrichtung (1) erweitert wird.

15. Vorrichtung nach einem der vorhergehenden Ansprüche, dadurch gekennzeichnet, daß am Gehäuse (4) eine Grifffläche (55) angeformt ist, die sich auf der dem Grundsockel (3) abgewandten Seite in Längsrichtung erstreckt.

16. Vorrichtung nach Anspruch 15, dadurch gekennzeichnet, daß der nicht von der Grifffläche (55) durchdrungene Bereich des Gehäuses (4) in seinem Inneren einen Anschlußraum (64) für die Verbindungsleitungen bildet.

17. Vorrichtung nach einem der vorhergehenden Ansprüche, dadurch gekennzeichnet, daß das Gehäuse (4) einen Bereich (56) aufweist, der sich in einem Winkel von 30° zur Oberseite (61) des Gehäuses (4) von der Oberseite (61) zur Vorderseite erstreckt.

## Claims

1. A device for receiving, preparing, utilising and transmitting electrical signals having a principal socket, fixed detachably to a wall rail, for connecting the connection lines for the transmission of measurement signals and the electrical energy necessary for the device to function, the device also having an evaluation device for preparing and utilising the received measurement signals, a transformer for converting the supply voltage into operating voltage, and a casing enclosing the principal socket, the evaluation device and the transformer, characterised by the following features:
a) the evaluation device (1), the transformer (2) and the principal socket (3) are self-contained functional elements;
b) the casing (4) has areas (41, 42, 46) which are formed by electrically insulating separating walls (44, 45) and into each of which one of the functional elements comprising the evaluation device (1), the transformer (2) or the principal socket (3) can be inserted;
c) the principal socket (3) has interior connection terminals (32, 37, 38) for connecting the connection lines transmitting the measuring signals and supply voltages, and also has plug-in connection parts (34, 36);
d) the evaluation device (1) and the transformer (2) have plug-in connection parts (12, 24) which engage in the plug-in connection parts (34, 36) of the principal socket (3) when the functional elements (1, 2, 3) are inserted into the associated areas (41, 42, 46) of the casing (4);
e) the principal socket (3) has a printed circuit board (31), the tracks of which are in electrical contact with the connection terminals (32, 37, 38) and with the plug-in connection parts (34, 36) and exclusively create the electrical connections between the functional elements (1, 2, 3) themselves and also between the connection lines.

2. A device according to claim 1, **characterised in that** guiding means and securing means (17, 18, 23, 35, 53, 54) are provided on the functional elements (1, 2, 3) or on the casing (4), these means guiding and holding the functional elements (1, 2, 3) in the associated areas (41, 42, 43) of the casing (4).

3. A device according to claim 1 or 2, **characterised in that** the electrical components of the transformer (2) are enclosed by an electrically insulating casing (21).

4. A device according to claim 3, **characterised in that** resilient means (23) are provided on the casing (21) of the transformer (2), the said means (23) engaging in the apertures (35) of the principal socket (3), when the transformer (2) and the principal socket (3) are inserted in the casing (4).

5. A device according to claim 3 or 4, **characterised in that** cooling ribs (22) are arranged, running transversely, on the surface of two exterior walls (26, 27) of the casing (21) of the transformer (2), the walls being at right angles to each other and running longitudinally.

6. A device according to claim 5, **characterised in that** the casing (4) has a recess (57) in which the transformer (2) is held in such a way that the external walls (26, 27) of the transformer (2) which hold the cooling ribs (26) form a continuation of the surface area of the casing (4), and the cooling ribs (26) protrude from the surface of the casing (4).

7. A device according to one of claims 1 to 6, **characterised in that** the principal socket (3) is made of an electrically insulating material.

8. A device according to claim 7, **characterised in that** the insulating parts of the connection terminals (32, 37, 38) and the plug-in connection parts (34, 36) of the principal socket are moulded integrally with the principal socket (3).

9. A device according to claim 7 or 8, **characterised in that** the exterior wall of the principal socket (3) has apertures (39) through which resilient members (60) may be inserted, which can be brought into electrical contact with tracks of the printed circuit board (31) in order to create connections between two devices arranged next to each other.

10. A device according to one of the preceding claims, **characterized in that** the casing (4) is manufactured from an insulating plastic.

11. A device according to claim 10, **characterized in that** the casing is manufactured from an acrylonitrile-butadiene-styrene copolymer, as a moulded article.

12. A device according to one of the preceding claims, **characterized in that** opposite parts (51, 52), which connect the transformer (2), the principal socket (3) and the casing (4) to each other in such a way that they are dust-tight, are moulded onto the casing (4), the transformer (2) and the principal socket (3).

13. A device according to one of the preceding claims, **characterized in that**, on its side opposite to the principal socket (3), the casing (4) has an aperture (41) in which the evaluation device (1) may be inserted.

14. A device according to claim 13, **characterized in that** tiltable casing parts (53, 54), through which the aperture (41) for insertion and removal of the evaluation device is extended, are provided on the casing (4).

15. A device according to one of the preceding claims, **characterized in that** a gripping surface (55) is integrally moulded on the casing (4), the said gripping surface extending longitudinally along the side opposite the principal socket (3).

16. A device according to claim 15, **characterized in that** the area of the casing (4), which the gripping surface (55) does not reach, forms an interior connection space (64) for the connection lines.

17. A device according to one of the preceding claims, **characterized in that** the casing (4) has an area (56) which extends at an angle of 30° with respect to the upper surface (61) of the casing (4) from the upper surface (61) to the front side.

## Revendications

1. Dispositif pour recevoir, préparer, exploiter et transmettre des signaux électriques, avec un socle formant embase fixé de manière amovible à une réglette murale pour brancher des conducteurs de liaison pour transmettre les signaux de mesure et l'énergie électrique nécessaire au fonctionnement du dispositif, un dispositif d'exploitation pour préparer et exploiter les signaux de mesure reçus, un transformateur pour convertir la tension d'alimentation en la tension de service, et avec un boîtier entourant le socle formant embase, le dispositif d'exploitation et le transformateur, caractérisé en ce qu'il présente les particularités suivantes:
a) le dispositif d'exploitation (1), le transformateur (2) et le socle formant embase (3) sont chacun un élément fonctionnel complet en lui-même;
b) le boîtier (4) présente des zones (41, 42, 46) formées par des cloisons électriquement isolantes (44, 45), dans chacune desquelles un des éléments fonctionnels formés par le dispositif d'exploitation (1), le transformateur (2) et le socle formant embase (3), respectivement, peuvent être introduits;
c) le socle formant embase (3) présente dans son intérieur des bornes de raccordement (32, 37, 38) pour connecter les conducteurs de liaison transmettant les signaux de mesure et les tensions d'alimentation, ainsi que des connecteurs (34, 36);
d) le dispositif d'exploitation (1) et le transformateur (2) présentent des connecteurs (12, 24) qui s'enfichent dans les connecteurs (34, 36) du socle formant embase (3) lorsque les éléments fonctionnels (1, 2, 3) sont introduits dans les zones correspondantes (41, 42, 46) du boîtier (4);
e) le socle formant embase (3) présente une plaquette à circuit imprimé (31) dont les pistes conductrices sont en contact électrique avec les bornes de raccordement (32, 37, 38) et avec les connecteurs (34, 36) et assurent uniquement les liaisons électriques des éléments fonctionnels (1, 2, 3) entre eux et avec les conducteurs de liaison.

2. Dispositif selon la revendication 1, caractérisé en ce qu'il est prévu sur les éléments fonctionnels (1, 2, 3) et sur le boîtier (4) des moyens de guidage et de fixation (17, 18, 23, 35, 53, 54) qui guident et maintiennent les éléments fonctionnels (1, 2, 3) dans les zones correspondantes (41, 42, 43) du boîtier (4).

3. Dispositif selon les revendications 1 ou 2, caractérisé en ce que les composants électriques du transformateur (2) sont entourés d'un boîtier électriquement isolant (21).

4. Dispositif selon la revendication 3, caractérisé en ce que des moyens formant ressort (23) sont prévus sur le boîtier (21) du transformateur (2) qui s'engagent dans des ouvertures (35) du socle formant embase (3) lorsque le transformateur (2) et le socle formant embase (3) sont introduits dans le boîtier (4).

5. Dispositif selon les revendications 3 ou 4, caractérisé en ce que sur la surface extérieure de deux parois extérieures (26, 27) du boîtier (21) du transformateur (2) disposées sous un angle de 90° l'une par rapport à l'autre et s'étendant dans la direction longitudinale, sont disposées des nervures de refroidissement (22) s'étendant dans la direction transversale.

6. Dispositif selon la revendication 5, caractérisé en ce que le boîtier (4) a un évidement (57) dans lequel le transformateur (2) est maintenu de telle manière que les parois extérieures (26, 27) du transformateur (2) présentant les nervures de refroidissement (26) forment le prolongement de la surface extérieure du boîtier (4) et les nervures de refroidissement (26) font saillie sur la surface extérieure du boîtier (4).

7. Dispositif selon l'une des revendications 1 à 6, caractérisé en ce que le socle formant embase (3) est constitué d'une matière électriquement isolante.

8. Dispositif selon la revendication 7, caractérisé en ce que les parties isolantes des bornes de raccordement (32, 37, 38) et des connecteurs (34, 36) du socle formant embase sont formées en une seule pièce avec le socle formant embase (3).

9. Dispositif selon la revendication 7 ou 8, caractérisé en ce que la paroi extérieure du socle formant embase (3) présente des ouvertures (39) par lesquelles des éléments formant ressorts (60) peuvent être passés qui sont à mettre en contact électrique avec des pistes conductrices de la plaquette à circuit imprimé (31) pour créer des liaisons entre deux dispositifs disposés l'un à coté de l'autre.

10. Dispositif selon l'une des revendications précédentes, caractérisé en ce que le boîtier (4) est fabriqué dans une matière plastique isolante.

11. Dispositif selon la revendication 10, caractérisé en ce que le boîtier est fabriqué sous la forme d'une pièce injectée constituée d'un copolymère acrylonitrile-butadiène-styrol.

12. Dispositif selon l'une des revendications précédentes, caractérisé en ce que sur le boîtier (4), le transformateur (2) et le socle formant embase (3) sont moulées des pièces en regard (51, 52) qui relient entre eux de manière étanche à la poussière le transformateur (2), le socle formant embase (3) et le boîtier (4).

13. Dispositif selon l'une des revendications précédentes, caractérisé en ce que le boîtier (4), du côté opposé au socle formant embase (3), a une ouverture (41) dans laquelle le dispositif d'exploitation (1) est introduit.

14. Dispositif selon la revendication 13, caractérisé en ce que des parties de boîtier pouvant pivoter vers l'extérieur (53, 54) sont présentes sur le boitier (4) et élargissent l'ouverture (41) pour l'introduction et l'enlèvement du dispositif d'exploitation (1).

15. Dispositif selon l'une des revendications précédentes, caractérisé en ce qu'une surface de préhension (55) est moulée dans le boîtier (4), cette surface s'étendant dans la direction longitudinale sur le côté opposé au socle formant embase (3).

16. Dispositif selon la revendication 15, caractérisé en ce que la zone du boitier (4) non traversée par la surface de préhension (55) forme dans son intérieur un espace de raccordement (64) pour les conducteurs de liaison.

17. Dispositif selon l'une des revendications précédentes, caractérisé en ce que le boîtier (4) présente une zone (56) qui s'étend du côté supérieur (61) au côté antérieur du boîtier sous un angle de 30° par rapport au côté supérieur (61) du boîtier (4).
